# EUROPEAN PATENT APPLICATION

(11) **EP 4 019 664 A1**
(43) Date of publication of application: **29.06.2022**
(21) Application number: 21209680.4
(22) Date of filing: 22.11.2021
(51) Int. Cl.: C23C 16/02, C23C 16/04, C23C 16/08, C23C 16/06, C23C 16/30, C23C 16/448, C23C 28/00, C04B 35/622, C04B 35/628, C22C 47/00, C22C 1/10, C04B 35/80, C23C 14/14, C23C 14/18, C23C 14/30, C22C 49/00

(54) **METHOD AND ARTICLE FOR METAL VAPOR INFILTRATION OF CMC PARTS**

(30) Priority: 23.12.2020 US 202017132215
(71) Applicant: Raytheon Technologies Corporation, Farmington, CT 06032 (US)
(72) Inventor: Borkowski, Luke, West Hartford, 06117 (US); Staroselsky, Alexander, Avon, 06001 (US); Srinivasan, Gajawalli V., South Windsor, 06074 (US); She, Ying, East Hartford, 06118 (US)
(74) Representative: Dehns

(57) **Abstract**

A method comprises discharging from a metal vaporization device a vapor of a metal or a metal precursor to a chemical vapor infiltration device where the chemical vapor infiltration device is in fluid communication with the metal vaporization device. The chemical vapor infiltration device contains a preform containing ceramic fibers. The preform is infiltrated with a metallic coating or a coating of a metallic precursor along with a ceramic precursor coating. The metallic coating and/or the metallic precursor coating and the ceramic precursor coating are applied sequentially or simultaneously.

## Description

### BACKGROUND

Disclosed herein is a method for metal vapor infiltration of ceramic matrix composites and articles containing the same.

Ceramic matrix composites (CMCs) offer a higher temperature, lower density alternative to nickel and cobalt superalloys for turbine parts such as seals, blades, and vanes. These CMC parts are often attached to metallic structures (e.g., CMC blade to a nickel superalloy disk). Because of the transition in materials from the CMC parts to the metallic structures, various issues can occur due to a mismatch in mechanical, thermal, and chemical properties between the two neighboring materials. For example, a mismatch in the coefficient of thermal expansion (CTE) and thermal conductivity between the CMC parts and the metallic structures can cause stress concentrations to occur at the interface which may lead to damage and premature failure. Another issue that occurs when attaching silicon carbide (SiC) CMCs to nickel substrates is the chemical reaction and diffusion that occurs at high temperatures between SiC and most metals (e.g., Ni, Co, Ti, Cr) leading to the creation of silicides. Silicide formation is accompanied by carbon precipitation in the form of graphitic layers which weaken the joint at the interface between the silicon carbide CMCs and the nickel substrate. Therefore, the brittle silicide phase which forms at the interface is susceptible to premature cracking, which can propagate into the CMC. Additionally, the difference in toughness between the ceramic and metallic materials can lead to concentrated cracking occurring near the CMC surface because of localized contact stresses.

### SUMMARY

In an embodiment, a method (e.g. a method using an article as herein disclosed) comprises discharging from a metal vaporization device a vapor of a metal or a metal precursor to a chemical vapor infiltration device where the chemical vapor infiltration device is in fluid communication with the metal vaporization device. The chemical vapor infiltration device contains a preform containing ceramic fibers. The preform is infiltrated with a metallic coating or a coating of a metallic precursor along with a ceramic precursor coating; or a metallic coating or a coating of a metallic precursor is disposed upon the preform, and a ceramic precursor coating is disposed upon the preform. The metallic coating and/or the metallic precursor coating and the ceramic precursor coating are applied sequentially or simultaneously.

In some embodiments, the ceramic precursor coating and the metallic coating or the metallic precursor coating are varied such that there is a gradient in a metal concentration from a region of majority ceramic content in the preform to a region of majority metal content.

In some embodiments, the vapors of the metal or vapors of the metal precursor are generated via chemical vapor deposition or electron beam plasma vapor deposition in the metal vaporization device.

In some embodiments, the metal vapor includes vapor of an alloy.

In some embodiments, a diffusion barrier layer is applied in the preform. In some embodiments, the method further comprises producing a diffusion barrier layer in the preform.

In some embodiments, the diffusion barrier layer comprises silver.

In some embodiments, the ceramic precursor coating is produced by ceramic precursors of SiC, A1₂O₃, BN, B₄C, Si₃N₄, MoSi₂, SiO₂, SiOC, SiNC, and/or SiONC.

In some embodiments, the preform comprises fibers that comprise silicon carbide (SiC), carbon, alumina (Al₂O₃), mullite (Al₂O₃-SiO₂), or a combination thereof.

In some embodiments, the gradient is a linear gradient.

In some embodiments, the gradient is a curvilinear gradient.

In some embodiments, the gradient is a step gradient.

In some embodiments, the method further comprises masking a region of the preform. In some embodiments, the region of the preform is masked during the infiltration of the metal vapors, the metal precursor vapors and/or the ceramic precursor vapors.

In an embodiment, an article (e.g. an article used in the method as herein disclosed) comprises a metal vaporization device and a chemical vapor infiltration device. The metal vaporization device is in fluid communication with the chemical vapor infiltration device. The chemical vapor infiltration device is downstream of the metal vaporization device. The article is operative to dispose on a portion of a preform a metal and a ceramic such that there is a gradient in a metal concentration from a region of majority ceramic content in the preform to a region of majority metal content.

In some embodiments, the metal vaporization device generates metal vapors or metal precursor vapors via chemical vapor deposition or electron beam plasma vapor deposition.

In some embodiments, a flow rate of metal vapors and ceramic precursor vapors are introduced into the chemical vapor infiltration device to produce a gradient in metal concentration in the preform.

In some embodiments, a flow rate of metal precursor vapors and ceramic precursor vapors are introduced into the chemical vapor infiltration device to produce a gradient in metal concentration in the preform.

### BRIEF DESCRIPTION OF THE FIGURES

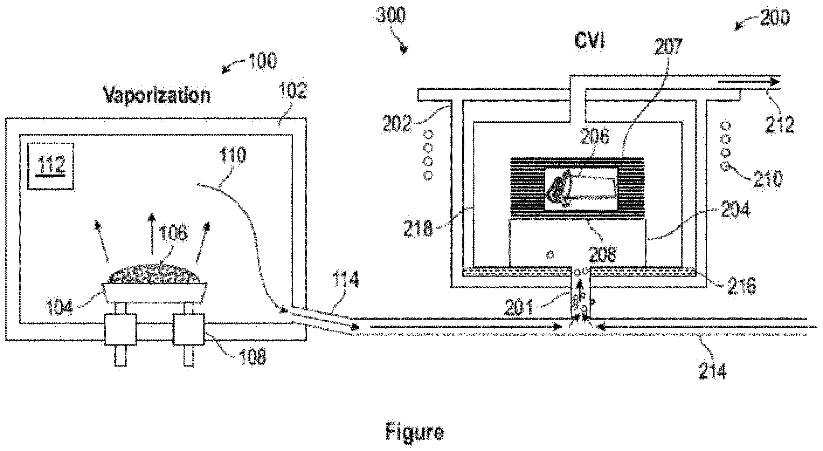

The Figure is a schematic diagram of an exemplary device that may be used to facilitate incorporation of a metallic phase into a ceramic matrix composite.

### DETAILED DESCRIPTION

Disclosed herein is a method for incorporating a metallic phase into a ceramic matrix composite (CMC) when the ceramic matrix composite is a preform. The ceramic matrix composite (hereinafter the "composite") eventually contacts a metal part (of an article such as, for example, seals, blades and vanes) and the presence of the metallic phase in the ceramic matrix brings about a compatibility between the ceramic matrix composite and the metal part. This compatibility which may be physical, thermal and/or chemical prevents cracking and distortion at the interface of the ceramic matrix composite and the metal part.

The method comprises infiltrating a metal vapor into a ceramic matrix composite preform during the manufacturing of the preform by coupling a metal vaporization device with the chemical vapor infiltration (CVI) apparatus that is used to manufacture the composite.

By coupling a metal vaporization device with the chemical vapor infiltration (CVI) method of manufacturing composites, it is possible to adjust the proportions of ceramic and metallic matrix material to locally control the mechanical, thermal, and chemical properties. The method involves a CVI process fed by the effluent from a metal vaporization process along with composite precursor. Using this method, the infiltration of metal vapor can be directed to specific locations in the article such as, for example, the root of a CMC blade in a turbine. This will allow the CMC part at this location to have mechanical and chemical properties that more closely match that of the adjoining part.

The Figure is a depiction of a manufacturing device 300 that comprises a metal vaporization device 100 in fluid communication with a chemical vapor infiltration device 200. The metal vaporization device 100 comprises a first chamber 102 that comprises a crucible 104 that retains a desired metal or metal precursor 106. Combinations of a metal and a metal precursor may also be held in the crucible 104. The crucible 104 and its contents may be heated with a heat source 108. The heat source 108 may heat the crucible 104 and its contents (the metal or metal precursor 106) by convection, conduction, radiation, or a combination thereof. In an exemplary embodiment, the heat source 108 heats the crucible 104 and its contents by convection.

The contents of the crucible may be a metal or a metal precursor. Suitable metals include transition metals, alkali metals, alkaline earth metals, rare earth metals, or a combination thereof.

Suitable examples of metals that may be contained in the crucible are iron, cobalt, tin, nickel, aluminum, zinc, titanium, zirconium, silicon, vanadium, molybdenum, gallium, indium, thallium, platinum, magnesium, manganese, tin, lithium, chromium, tungsten, gold, palladium, silver, or the like, or a combination thereof. When the crucible contains a metal, the heat source 108 heats the metal to above its boiling point and vapors 110 of the metal (in gaseous phase) are transported to the chemical vapor infiltration device 200 via an exit port 114.

In an embodiment, a metal precursor may be used in the crucible 104. Metal precursors are typically salts that can be evaporated (e.g., a gaseous phase 110) and discharged into the chemical vapor infiltration device 200 via an exit port 114 in the first chamber 102. The chemical vapor infiltration device 200 comprises a second chamber 202 (the chemical vapor infiltration chamber 202) that contains a preform 206 into which the precursor vapors are deposited. A precursor [e.g., methyltrichlorosilane (MTS), a precursor for the SiC deposit, along with hydrogen] may then be introduced into the chemical vapor infiltration chamber 202 to deposit SiC into the preform. The evaporation of a metal and/or a metal precursor to generate vapors that are eventually deposited on a preform is also known as chemical vapor deposition (CVD).

Exemplary salt cations include iron, cobalt, tin, nickel, aluminum, zinc, titanium, zirconium, silicon, vanadium, molybdenum, gallium, indium, thallium, platinum, magnesium, manganese, tin, lithium, chromium, tungsten, gold, palladium, silver, or the like, or a combination thereof. Exemplary salt anions include chloride, bromide, fluoride, iodide, sulfate, nitrate, phosphate, arsenate, chlorite, thiosulfate, sulfite, perchlorate, carbonate, chromate, hydrogen carbonate or bicarbonate, chlorate, bromate, iodate, fluorate, or the like, or a combination thereof.

Exemplary salts are salts of nickel, cobalt, aluminum, zirconium, titanium, silver, or a combination thereof. Examples of suitable salts are nickel sulfate, nickel chloride, nickel phosphate, cobalt phosphate, cobalt chloride, cobalt sulfate, nickel nitrate, cobalt nitrate, titanium chloride, chromium chloride, chromium sulfate, chromium nitrate, chromium phosphate, aluminum chloride, aluminum nitrate, or the like, or a combination thereof.

It is to be noted that the metal vapor or the metal precursor vapors may include a combination that produce metal alloys in the preform.

In another exemplary embodiment, the contents of the crucible 104 may be heated in a manner similar to that in electron-beam physical vapor deposition (EBPVD). In physical vapor deposition, the contents of the crucible 104 are bombarded with an electron beam given off by a charged tungsten filament 112 under high vacuum. The electron beam causes atoms from the target (the contents of the crucible) to transform into a vapor (e.g., a gaseous phase) 110, which is then transported to the chemical vapor infiltration chamber 202 via exit port 114 in the first chamber 102. This gaseous phase derived from physical vapor deposition is then disposed on the preform.

With reference now once again to the Figure, the chemical vapor infiltration device 200 comprises a second chamber 202 that functions as a furnace and is encompassed by the furnace casing. The second chamber 202 comprises an inlet port 201 that is in fluid communication with the first chamber 102 via outlet port 114 as well as with a source of a ceramic precursor via a precursor port 214. The second chamber 202 is therefore downstream of first chamber 102. The second chamber 202 contains a support 204 that comprises a sample holder 207 for holding the preform in place. The support 204 contains a perforated bottom plate 208 through which metal vapors and/or metal precursor vapors from the first chamber 102 may contact the preform (after entering the second chamber through inlet port 201). Vapors of the ceramic precursor may also contact the preform through the perforated bottom plate 208 after entering the second chamber through inlet port 201.

The second chamber 202 which functions as a furnace is heated by an induction coil 210 or alternatively by other means involving heat convection or radiation. The furnace contains a graphite susceptor 218. The graphite susceptor absorbs electromagnetic energy from the induction coils and converts it to heat. It is used to transfer heat uniformly to the preform through conduction or radiation to avoid local overheating. The second chamber 202 also contains an exhaust port 212 through which reaction byproducts and unreacted reactants can exit the vapor infiltration chamber 202.

The second chamber 202 contains a hollow section between the outer wall and the graphite susceptor 218 through which a cooling fluid 216 is circulated. The induction coil 210 along with the cooling fluid 216 are used to control the temperature of the second chamber 202 during the vapor infiltration into the perform 206.

As noted above, the second chamber receives metal vapors or metal precursor vapors from the first chamber. The second chamber also receives ceramic precursor vapors. The ceramic precursor vapors as well as the metal/metal precursor vapors infiltrate the preform located in the preform sample holder 207. Typical preforms and the ceramic precursors that infiltrate to deposit on the preform fibers to form the ceramic matrix will now be briefly described.

In one embodiment ceramic fibers of preform are single crystal fibers, polycrystalline fibers or amorphous fibers. In an embodiment, ceramic fibers of the preform plies can comprise silicon carbide (SiC), carbon, alumina (Al₂O₃), mullite (Al₂O₃-SiO₂), or a combination thereof. The preform can have any desired shape and is typically a laminate. Where fibers of a preform are provided by a SiC fiber a matrix consisting of, e.g., SiC, Al₂O₃, BN, B₄C, Si₃N₄, MoSi₂, SiO₂, SiOC, SiNC, and/or SiONC can be formed on fibers of the preform to define a densified CMC structure.

The preform provides reinforcement for a ceramic matrix composite (CMC) formed by subjecting the preform to CVI. In this embodiment, the preform is infiltrated with ceramic precursors and metal/metal precursor vapors. An appropriate gas for CVI can include, for example, any one of, or a mixture of two or more of, hydrogen, methyl-trichlorosilane, boron trichloride, ammonia, trichlorosilane, and a hydrocarbon gas. An appropriate gas can include, e.g., any silane containing vapor as well as any siloxane, silazane, or other silicon containing vapor. The gas within the CVI treatment chamber (the second chamber 202) can be devoid of a primary flow direction. Providing a gas within the second chamber 202 to be devoid of a primary flow direction can reduce processing cost.

In one embodiment, in one method of using the device 300, a plurality of plies are laminated together to form the preform 206. The plies comprise ceramic fibers. The preform 206 may be formed into a desired shape prior to being placed in the preform sample holder 207 in the chemical vapor infiltration chamber (the second chamber 202). A ceramic precursor vapor is first introduced into the second chamber 202 (which is set to the appropriate temperature and pressure) to infiltrate parts of the preform. The ceramic precursor vapor infiltrates the desired parts of the preform and undergoes densification to form the ceramic. Once the preform is densified to a sufficient degree with ceramic (e.g., SiC), masking can be applied to selectively allow the subsequent vapor infiltration to take place in desired locations such as near the surface of the preform. The subsequent infiltration into the partly-completed densified preform is conducted with vapors from both the metal vaporization device 100 as well as the chemical vapor infiltration device 200. The ratio of metal vapors to ceramic vapors that contacts the preform can be controlled to permit the desired ratio of metal to ceramic to densify in the partly-completed densified preform.

In order to generate vapors from the metal vaporization device 100, a desired metal or a metal precursor is introduced into the crucible. The metal (and/or metal precursor) vapors are generated by heating the crucible using convection currents and/or radiation (e.g., microwaves, infrared radiation) to the appropriate temperature. In an embodiment, electron-beam plasma vapor deposition may be used in conjunction with the convection currents and/or with other forms of radiation (e.g., microwaves, infrared radiation) to produce the desired vapors. The metal (and/or metal precursor) vapors are transported to the chemical vapor infiltration device 200 via exit port 114 to contact the partly-completed densified preform. Ceramic precursor vapors may simultaneously or sequentially be introduced into the chemical vapor infiltration device 200 to contact the partly-completed densified preform.

In an embodiment, a mixture of metal (and/or metal precursor) vapors and ceramic precursor vapors may simultaneously be allowed into the second chamber 202 to contact the preform and to form a two-phase blend of metal (and/or metal precursor) and ceramic on the partly-completed densified preform. In another embodiment, the metal (and/or metal precursor) vapors and the ceramic precursor vapors are sequentially allowed into the second chamber 202 to contact the partly-completed densified preform. The weight ratio of the metal (and/or metal precursor) vapors to the ceramic precursor vapors may be controlled by a computer (not shown) and a plurality of valves (not shown) and/or pumps (not shown).

When metal precursor vapors are discharged from the metal vaporization device 100 to the chemical vapor infiltration device 200, a reactant (that reduces the metal precursor to a metal) may be introduced into the chemical vapor infiltration device 200. In an embodiment, when the metal precursor is a salt, the reactant is a reducing agent, such as for example, hydrogen. For example, if nickel sulfate vapors are charged to the chemical vapor infiltration device 200 from the metal vaporization device 100, hydrogen may also be simultaneously introduced into the chemical vapor infiltration device 200 to reduce the nickel sulfate to nickel, while releasing sulfuric acid vapors that are discharged from the chamber 202 via exhaust port 212 to a scrubber (not shown) or to a storage vessel (not shown).

The transition from ceramic to metal in the partly-completed densified preform can be done gradually (i.e., functionally graded) to achieve a smooth transition of properties until the final outer layer is primarily metallic with similar properties to the attachment structure. In an embodiment, the transition from ceramic to metal is a linear gradient with weight ratios of the ceramic component to metal component transitioning in gradual linear fashion. In another embodiment, this gradient may be curvilinear.

The gradient may also follow a step function if desired. In an embodiment, parts of the partly-completed densified preform may be protected with a mask to prevent the deposition of either the metal (or metal precursor) vapors or the ceramic precursor vapors. The mask may be removed when the operation is concluded. Masking also prevents the undesirable deposition of metals or ceramics in regions where it is not desired. In an embodiment, when a turbine airfoil (blade or vane) root is being graded, the deposition of metal on the hotter platform and blade can be controlled or prevented via masking.

In an embodiment, a first metal layer that is deposited on the partly-completed densified preform may function as a diffusion barrier. The diffusion barrier prevents diffusion of the subsequent vapors of metal/metal precursor or the ceramic precursor from diffusing into the interstices of the partly-completed densified preform. In an embodiment, a first metal layer that is deposited on the partly-completed densified preform as the diffusion barrier may be the same or different from the metal that is later deposited to functionally grade the preform. Silver may be used to form the first metal layer that functions as the diffusion barrier.

Subsequent layers of metal/metal precursor and the ceramic precursor are then infiltrated/deposited in order to functionally grade the partly-completed densified preform such that there is a gradual variation in properties such as coefficient of thermal expansion, density, chemical compatibility, and the like. The gradation varies from that of the ceramic matrix to that of the metal that the finished preform contacts. In an embodiment, when the ceramic matrix comprises silicon carbide and the metal part that the finished preform eventually contacts comprises Inconel, the gradient in a portion of the preform is varied from comprising a majority of silicon carbide to a majority of Inconel.

In an embodiment, the metal vapor is not only targeted at small cracks within the matrix, but rather toward a specific region like the root of a turbine blade, which will be in contact with the rotor. By using a gradient in metal composition (relative to the ceramic matrix) at the root of the turbine blade, the portion of the root that contacts the rotor will have a larger amount of metal of the same type as the metal of the rotor. The portion of the root that contacts the turbine blade will have a higher concentration of the ceramic (of the same composition as the ceramic matrix).

This grading will essentially be a gradual gradient (either linear or curvilinear) since once the diffusion barrier is infiltrated/deposited, further infiltration and contact with the ceramic matrix will be prevented and subsequent layers will be sequenced linearly on top of the diffusion barrier.

In one embodiment, with respect to a turbine blade that comprises silicon carbide (SiC) in contact with a rotor that comprises a metal, the central cross-sectional area of the blade root will comprise silicon carbide fibers encapsulated by a silicon carbide ceramic matrix composite. Farther away from the central cross-sectional area there would be a thin layer of a diffusion barrier metal, followed by subsequent layers of different metals or metallic alloys (or metal carbides) interspersed with the ceramic matrix composite until the final layer with properties matching those of the rotor is deposited.

These layers could be distinct, however, with the disclosed method, it would be possible to continuously grade the metal composition to obtain more gradual transition of properties. The gradual transition of properties (esp. thermal properties) would mitigate cracking due to thermal mismatch. Therefore, the finished part in the region of interest would be less like a particulate composite (e.g., cement) and more like a fiber composite covered with a layered, sequenced structure.

The claimed invention is advantageous because of its ability to infiltrate and coat the ceramic (e.g., silicon carbide) matrix with a layer of diffusion barrier material. For example, a benefit of this method over other approaches (e.g., foil, melt infiltrate) is that full coverage of the SiC matrix can be achieved (even on curved structures) with a small amount of diffusion barrier material. The proposed method addresses a current need for a solution to permit ceramic matrix composite/metal mating without interface embrittlement driven by diffusion. Furthermore, because of the generality of the infiltration method, a wide range of current and future diffusion barrier materials can be infiltrated into the ceramic matrix composite using this method.

While the invention has been described with reference to some embodiments, it will be understood by those skilled in the art that various changes may be made and equivalents may be substituted for elements thereof without departing from the scope of the invention. In addition, many modifications may be made to adapt a particular situation or material to the teachings of the invention without departing from essential scope thereof. Therefore, it is intended that the invention not be limited to the particular embodiments disclosed as the best mode contemplated for carrying out this invention, but that the invention will include all embodiments falling within the scope of the appended claims.

Certain embodiments of the present disclosure are as follows:
1. A method comprising:
   discharging from a metal vaporization device a vapor of a metal or a metal precursor to a chemical vapor infiltration device; where the chemical vapor infiltration device is in fluid communication with the metal vaporization device; where the chemical vapor infiltration device contains a preform containing ceramic fibers;
   disposing upon the preform a metallic coating or a coating of a metallic precursor;
   disposing upon the preform a ceramic precursor coating;
   where the metallic coating and the ceramic precursor coating are applied sequentially or simultaneously.
2. The method of embodiment 1, where the ceramic precursor coating and the metallic coating or the metallic precursor coating are varied such that there is a gradient in a metal concentration from a region of majority ceramic content in the preform to a region of majority metal content.
3. The method of embodiment 1, where the vapors of the metal or vapors of metal precursor are generated via chemical vapor deposition or electron beam plasma vapor deposition in the metal vaporization device.
4. The method of embodiment 1, where the metal vapor includes vapor of an alloy.
5. The method of embodiment 1, further comprising producing a diffusion barrier layer in the preform.
6. The method of embodiment 5, where the diffusion barrier layer comprises silver.
7. The method of embodiment 1, where the ceramic precursor coating is produced by ceramic precursors of SiC, Al₂O₃, BN, B₄C, Si₃N₄, MoSi₂, SiO₂, SiOC, SiNC, and/or SiONC.
8. The method of embodiment 1, where the preform comprises fibers that comprise silicon carbide (SiC), carbon, alumina (Al₂O₃), mullite (Al2O₃-SiO₂), or a combination thereof.
9. The method of embodiment 2, where the gradient is a linear gradient.
10. The method of embodiment 2, where the gradient is a curvilinear gradient.
11. The method of embodiment 2, where the gradient is a step gradient.
12. The method of embodiment 1, further comprising masking a region of the preform.
13. An article comprising:
   a metal vaporization device; and
   a chemical vapor infiltration device; wherein the metal vaporization device is in fluid communication with the chemical vapor infiltration device; where the chemical vapor infiltration device is downstream of the metal vaporization device;
   where the article is operative to dispose on a portion of a preform a metal and a ceramic such that there is a gradient in a metal concentration from a region of majority ceramic content in the preform to a region of majority metal content.
14. The article of embodiment 13, wherein the metal vaporization device generates metal vapors or metal precursor vapors via chemical vapor deposition or electron beam plasma vapor deposition.
15. The article of embodiment 13, where a flow rate of metal vapors and ceramic precursor vapors are introduced into the chemical vapor infiltration device to produce a gradient in metal concentration in the preform.
16. The article of embodiment 13, where a flow rate of metal precursor vapors and ceramic precursor vapors are introduced into the chemical vapor infiltration device to produce a gradient in metal concentration in the preform.

## Claims

1. A method comprising:
discharging from a metal vaporization device a vapor of a metal or a metal precursor to a chemical vapor infiltration device; where the chemical vapor infiltration device is in fluid communication with the metal vaporization device; where the chemical vapor infiltration device contains a preform containing ceramic fibers;
disposing upon the preform a metallic coating or a coating of a metallic precursor;
disposing upon the preform a ceramic precursor coating;
where the metallic coating and the ceramic precursor coating are applied sequentially or simultaneously.

2. The method of Claim 1, where the ceramic precursor coating and the metallic coating or the metallic precursor coating are varied such that there is a gradient in a metal concentration from a region of majority ceramic content in the preform to a region of majority metal content.

3. The method of Claim 1 or Claim 2, where the vapors of the metal or vapors of the metal precursor are generated via chemical vapor deposition or electron beam plasma vapor deposition in the metal vaporization device.

4. The method of any one of the preceding Claims, where the metal vapor includes vapor of an alloy.

5. The method of any one of the preceding Claims, further comprising producing a diffusion barrier layer in the preform, preferably where the diffusion barrier layer comprises silver.

6. The method of any one of the preceding Claims, where the ceramic precursor coating is produced by ceramic precursors of SiC, Al₂O₃, BN, B₄C, Si₃N₄, MoSi₂, SiO₂, SiOC, SiNC, and/or SiONC.

7. The method of any one of the preceding Claims, where the preform comprises fibers that comprise silicon carbide (SiC), carbon, alumina (Al₂O₃), mullite (Al₂O₃-SiO₂), or a combination thereof.

8. The method of any one of Claims 2-7, where the gradient is a linear gradient.

9. The method of any one of Claims 2-7, where the gradient is a curvilinear gradient.

10. The method of any one of Claims 2-7, where the gradient is a step gradient.

11. The method of any one of the preceding Claims, further comprising masking a region of the preform.

12. An article comprising:
a metal vaporization device; and
a chemical vapor infiltration device; wherein the metal vaporization device is in fluid communication with the chemical vapor infiltration device; where the chemical vapor infiltration device is downstream of the metal vaporization device;
where the article is operative to dispose on a portion of a preform a metal and a ceramic such that there is a gradient in a metal concentration from a region of majority ceramic content in the preform to a region of majority metal content.

13. The article of Claim 12, wherein the metal vaporization device generates metal vapors or metal precursor vapors via chemical vapor deposition or electron beam plasma vapor deposition.

14. The article of Claim 12 or Claim 13, where a flow rate of metal vapors and ceramic precursor vapors are introduced into the chemical vapor infiltration device to produce a gradient in metal concentration in the preform.

15. The article of any one of Claims 12-14, where a flow rate of metal precursor vapors and ceramic precursor vapors are introduced into the chemical vapor infiltration device to produce a gradient in metal concentration in the preform.
